(19) Europäisches Patentamt
European Patent Office
Office européen des brevets

(11) **EP 4 239 351 B1**

(12) **EUROPEAN PATENT SPECIFICATION**

(45) Date of publication and mention of the grant of the patent:
**04.06.2025   Bulletin 2025/23**

(21) Application number: **22203429.0**

(22) Date of filing: **24.10.2022**

(51) International Patent Classification (IPC):
**G01R 31/392** (2019.01)     **B60L 58/16** (2019.01)
**G01R 31/367** (2019.01)     **B60L 58/12** (2019.01)
**B60L 3/12** (2006.01)

(52) Cooperative Patent Classification (CPC):
**G01R 31/392; B60L 3/12; B60L 58/12; B60L 58/16; G01R 31/367;** B60L 2240/545; B60L 2240/547; B60L 2240/549; B60L 2260/44; Y02T 10/70

(54) **USING BATTERY SYSTEM PARAMETERS TO ESTIMATE BATTERY LIFE EXPECTANCY WITHIN ELECTRIC AND HYBRID ELECTRIC VEHICLES**

VERWENDUNG VON BATTERIESYSTEMPARAMETERN ZUR SCHÄTZUNG DER BATTERIELEBENSDAUER IN ELEKTRISCHEN UND HYBRIDEN ELEKTROFAHRZEUGEN

UTILISATION DE PARAMÈTRES DE SYSTÈME DE BATTERIE POUR ESTIMER L'ESPÉRANCE DE VIE DE BATTERIE DANS DES VÉHICULES ÉLECTRIQUES ET HYBRIDES ÉLECTRIQUES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:   **04.03.2022   US 202217686969**

(43) Date of publication of application:
**06.09.2023   Bulletin 2023/36**

(73) Proprietor: **Garrett Transportation I Inc.**
**Torrance, CA 90504 (US)**

(72) Inventors:
• **Poloni, Tomas**
**Torrance, 90504 (US)**
• **Pekar, Jaroslav**
**Torrance, 90504 (US)**

(74) Representative: **LKGlobal UK Ltd.**
**Cambridge House**
**Henry Street**
**Bath BA1 1BT (GB)**

(56) References cited:
**WO-A1-2010/055271     WO-A1-2021/014406**
**US-A1- 2017 003 352     US-B2- 10 209 314**

**Description**

FIELD

The invention pertains generally to electric and hybrid electric vehicles and more particularly to using battery system parameters to estimate battery life expectancy. Documents WO 2010/055271 A1 and US 10,209,314 B2, from the prior art, are disclosing examples of methods/systems estimating such battery life expectancy.

BACKGROUND

A variety of hybrid electric vehicles include an electric motor and an internal combustion engine. Inclusion of the electric motor (and associated power source such as a battery) permits improved fuel economy and reduced exhaust emissions. Electric vehicles do not include an internal combustion engine, and instead are entirely powered by the electric motor and associated power source. While a lot of research has gone into minimizing fuel consumption, it will be appreciated that battery performance can significantly affect the long-term performance of the hybrid electric vehicle in terms of monetary savings and desired energy efficiency. Accordingly, there is a desire for methods and systems for improving the life expectancy of the battery within electric and hybrid electric vehicles, and thus improve the long-term cost effectiveness of the electric and hybrid electric vehicles, by estimating the health of the battery within electric and hybrid electric vehicles.

OVERVIEW

The present inventors have recognized, among other things, that a problem to be solved is the need for new and/or alternative approaches for improving the life expectancy of a battery within an electric or hybrid electric vehicle, and thus improve the long-term cost effectiveness of the electric or hybrid electric vehicle, by estimating the health of the electric or hybrid electric vehicle battery, including the RUL (remaining useful life).

In embodiments encompassed by the wording of the claims, a method of diagnosing the health of a battery within an electric or hybrid electric vehicle is provided. The battery is configured to provide power for operation of the electric or hybrid electric vehicle, the electric or hybrid electric vehicle including a battery monitoring system. The method includes receiving battery condition signals from the battery monitoring system and using the received battery condition signals to estimate an SOH (state of health) of the battery and an SOC (state of charge) of the battery. The estimated SOH and the estimated SOC are used in combination with a degradation model to estimate one or more of a capacity loss-related parameter and an internal resistance-related parameter. The estimated capacity loss-related parameter and/or the internal resistance-related parameter are used to estimate a RUL (remaining useful life) value. A closed loop feedback is used to update the degradation model and the estimated RUL value over time are stored. The estimated RUL value are monitored for sudden changes. Using the estimated RUL value, an altered demanded torque profile from electric motors of the electric or hybrid electric vehicle is determined, the altered demanded torque profile being determined for increasing the life of the battery. The step of determining the altered demanded torque profile comprises using a model predictive control, MPC, analysis to minimize a cost function associated with the RUL value over a time horizon, wherein weighting terms in the MPC analysis are changed in response to sudden changes in the estimated RUL value so as to penalize actions that caused monitored sudden changes in the estimated RUL value.

Additionally, estimating the RUL value may further include using a time of battery usage value.

Additionally, estimating the RUL value may further include using a charge throughput value.

Additionally, the SOH of the battery may include a capacity value for the battery.

Additionally, the SOH of the battery may include an internal resistance value for the battery.

Additionally, receiving battery condition signals from the battery monitoring system may include receiving battery condition signals representing one or more of a battery current of the battery, a terminal voltage of the battery, a surface temperature of the battery, and a core temperature of the battery.

In embodiments encompassed by the wording of the claims, a system for providing power within an electric or hybrid electric vehicle is provided. The system includes a battery and a battery monitoring system that is configured to output signals representative of conditions within the battery. A battery diagnostics system is configured to receive the signals outputted by the battery monitoring system. The battery diagnostics system includes a state and health estimation block that is configured to output signals representing a current health state of the battery. The battery diagnostics system includes a health prognostics block configured to receive the signals outputted by the state and health estimation block. The health prognostics block includes a degradation model that is configured to output signals representing a loss of capacity within the battery and/or an internal resistance within the battery, and a lifetime prediction block that is configured to receive the outputted signals from the degradation model and to estimate an RUL (remaining useful life) value for the battery, to use a closed-loop feedback to update the degradation model and to store the estimated RUL value over time and to monitor the estimated RUL value for sudden changes. An engine management system is configured to determine, using the estimated RUL value, an altered demanded torque profile from electric motors of the electric or hybrid electric vehicle, the altered demanded torque profile for increasing the life of the battery, wherein the altered demanded torque profile is determined using a model predictive control, MPC, analysis adapted to minimize a cost function associated with the RUL value over a time horizon, wherein weighting terms in the MPC analysis are configured to be changed in response to sudden changes in the estimated RUL value so as to penalize actions that caused monitored sudden changes in the estimated RUL value.

Additionally, the lifetime prediction block may be configured to estimate the RUL value for the battery based on the signals outputted by the degradation model.

Additionally, the lifetime prediction block may be configured to estimate the RUL value for the battery based also on a time of battery usage value and/or a charge throughput value for the battery.

This overview is intended to provide an introduction to the subject matter of the present patent application. It is not intended to provide an exclusive or exhaustive explanation. The detailed description is included to provide further information about the disclosure.

BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.

Figure 1 is a schematic block diagram of an illustrative system for providing electrical power within an electric or hybrid electric vehicle;

Figure 2 is a schematic block diagram of an illustrative system for determining battery health within an electric or hybrid electric vehicle;

Figure 3 is a flow diagram showing an illustrative method;

Figure 4 is a flow diagram showing an illustrative method;

Figure 5 is a graphical representation showing a battery lifetime profile;

Figure 6 is a flow diagram showing an illustrative method;

Figure 7 is a graphical representation showing a battery costs breakdown for two different control scenarios;

Figure 8 is a graphical representation showing an illustrative battery degradation model;

Figure 9 is a graphical representation of a nominal scenario;

Figures 10A through 10D are graphical representations of battery parameters pertaining to the nominal scenario shown in Figure 9;

Figure 11 is a graphical representation of a sudden capacity change scenario;

Figures 12A through 12D are graphical representations of battery parameters pertaining to the sudden capacity change scenario shown in Figure 11; and

Figures 13A through 13D are graphical representations of battery parameters pertaining to two different control scenarios.

DETAILED DESCRIPTION

An electric vehicle may include an electric motor and a battery that is configured to provide electrical power to the electric motor in order to propel the electric vehicle. An electric vehicle does not include a secondary power source such as an internal combustion engine and accompanying fuel tank. A hybrid electric vehicle may include an electric motor and a battery that is configured to provide electrical power to the electric motor in order to propel the hybrid electric vehicle. A hybrid electric vehicle is known as a "hybrid" electrical vehicle because at least one other or "secondary" power source is available. Some hybrid electric vehicles include an internal combustion engine and a fuel tank holding fuel, such as gasoline or diesel, for the internal combustion engine. Some hybrid electric vehicles may use other power sources, such as a fuel cell, rather than an internal combustion engine. In some examples, a hybrid electric vehicle may be additionally configured to obtain electrical grid power, where such vehicles are known as plug-in hybrid vehicles, capable of using electrical power obtained from a grid as well as electrical power obtained from an internal combustion engine. Hybrid electrical vehicles may operate in different modes (full electrical, parallel electrical/secondary source, and full secondary source), and those modes may be limited in some vehicles and/or may change depending on driving conditions.

In some cases, for an electric vehicle, there may be some flexibility in how the electric motor is operated, including placing limitations on how much power can be withdrawn from the battery at a particular time, for example, or how much power can be withdrawn from the battery based at least in part upon how much charge remains within the battery. The vehicle management system may manage how the electric motor is operated. Knowing how the battery is performing, and having an idea of how long the battery will last, can be beneficial in optimizing the life of the battery.

For a hybrid electric vehicle having both an electric motor and an internal combustion engine, it will be appreciated that there can be some flexibility in how the vehicle is managed by its vehicle management system. Depending on a variety of conditions and parameters, it may be advantageous to run the internal combustion engine (or other secondary power source) a little more than strictly necessary in order to improve the life expectancy of the battery, for example. Knowing how the battery is performing, and having an idea of how long the battery will last, can be beneficial in optimizing the life of the battery. It will be appreciated that the batteries used to power the electric motor in electric and hybrid electric vehicles can represent a substantial investment for the vehicle's owner.

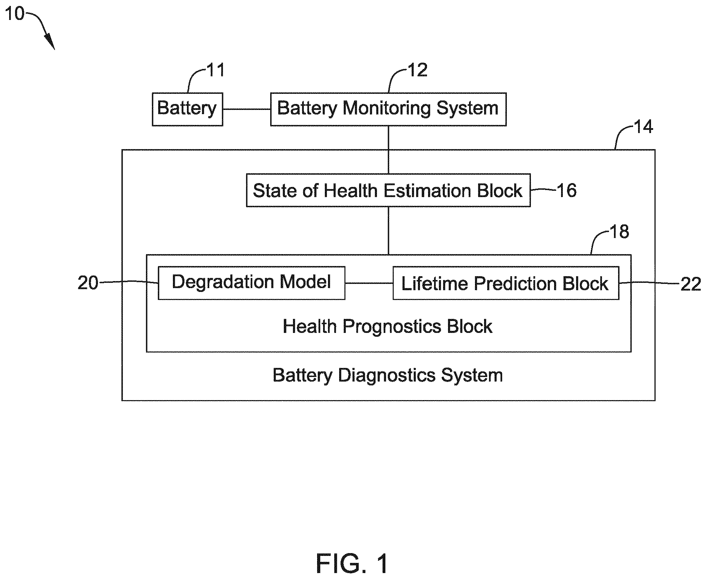

Figure 1 is a schematic block diagram of an illustrative system 10 for providing electrical power within an electric or hybrid electric vehicle. The system 10 includes a battery 11 and a battery monitoring system 12 that is configured to monitor the performance of the battery 11 and to output signals that are representative of conditions within the battery 11. In some cases, the battery monitoring system 12 may be part of an engine management system or even a vehicle management system. The battery monitoring system 12 may even be part of the battery 11, for example, taking the form of a microprocessor, microcontroller, application specific integrated circuit (ASIC), or other electrical logic, sensing and memory circuitry integrated with the battery itself. The battery monitoring system 12 may output signals that are used to monitor battery performance, such as but not limited to battery current, internal resistance, terminal voltage and/or surface temperature. In some cases, core temperature may be used instead of surface temperature.

The battery monitoring system 12 is operably coupled with a battery diagnostics system 14 that is configured to receive the signals that are outputted by the battery monitoring system 12. In some cases, the battery monitoring system 12 may be operably coupled with the battery diagnostics system 14 via a vehicle network, for example. The battery diagnostics system 14 includes a state and health estimation block 16 that is configured to output signals representing a current health state of the battery.

The battery diagnostics system 14 also includes a health prognostics block 18 that is configured to receive the signals outputted by the state and health estimation block 16. The health prognostics block 18 includes a degradation model 20 that is configured to output signals representing a loss of capacity within the battery 11 and/or changes to an internal resistance within the battery 11 and a lifetime prediction block 22 that is configured to receive the outputted signals from the degradation model 20 and to estimate an RUL (remaining useful life) value for the battery 11 and/or a CBW (cumulative battery wear cost) value for the battery 11.

In some instances, the lifetime prediction block 22 may be configured to estimate the RUL value and/or the CBW value for the battery based on the signals outputted by the degradation model. The lifetime prediction block 22 may be configured to estimate the RUL value and/or the CBW value for the battery 11 based also on a time of battery usage value and/or a charge throughput value for the battery 11.

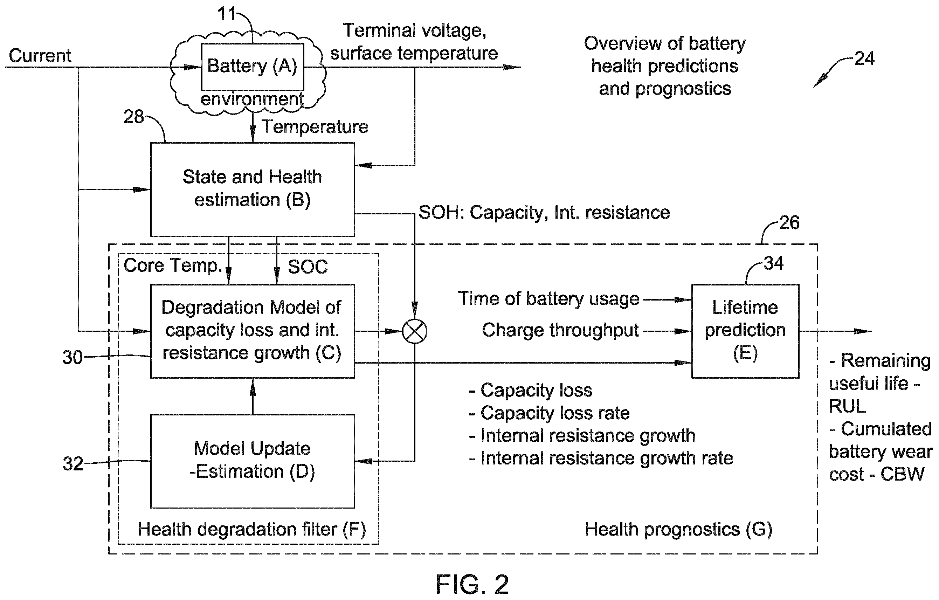

Figure 2 is a schematic block diagram of an illustrative diagnostic system 24. The diagnostic system 24 may be considered as being an example of the system 10 shown in Figure 1. Features ascribed to the system 24 may be considered as being applicable to the system 10. Similarly, features ascribed to the system 10 may be considered as being applicable to the system 24.

In the system 24, a predicted lifetime of the battery 11 may be estimated by the health prognostics filter 26. The health prognostics filter 26 receives inputs from a state and health estimation block 28. The state and health estimation block 28 provides an estimated state of charge (SOC) for the battery 11 and an estimated core battery temperature for the battery 11. The state and health estimation block 28 also provides up to date state of health information such as estimated latest capacity of the battery 11 and internal resistance within the battery 11.

The health prognostics filter 26 includes a degradation model 30 that processes an SOH (state of health) capacity error. This error is a difference between the capacity estimated by the state and health estimation block 28 and the battery capacity estimated by the degradation model 30. The degradation model 30 may utilize one or more different models for modeling battery degradation. For example, one such model describes the rate of capacity change as a function of current and state of charge for different cell/battery core temperatures. Another model may parametrize the rate of capacity change as a function of temperature and state of charge where the current is first mapped into the cell temperature.

A model update estimation block 32 provides closed-loop updating for the degradation model 30. The health prognostics filter 26 also includes a lifetime prediction block 34 that processes inputs such as time of battery usage, charge throughput, capacity loss and capacity loss rate in order to compute the RUL (remaining useful life) and CBW (cumulative battery wear) cost values.

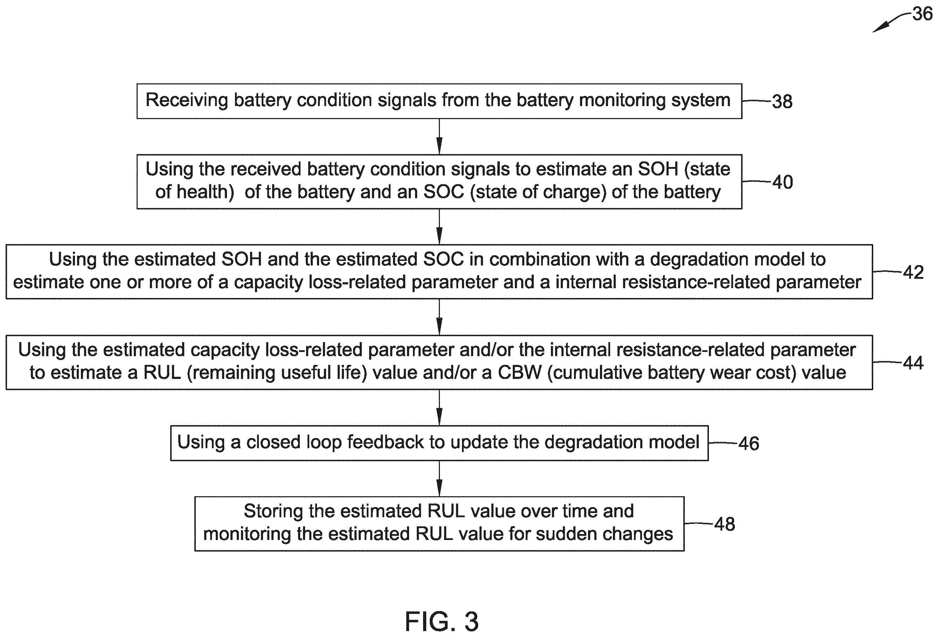

Figure 3 is a flow diagram showing an illustrative method of diagnosing the health of a battery (such as the battery 11) within an electric or hybrid electric vehicle, the battery configured to provide power for operation of the electric or hybrid electric vehicle, the electric or hybrid electric vehicle including a battery monitoring system (such as the battery monitoring system 10). The method 36 includes receiving battery condition signals from the battery monitoring system, as indicated at block 38. The battery condition signals may include battery condition signals that are commonly available within the vehicle management system of an electric or hybrid electric vehicle, for example. The battery condition signals may represent one or more of a battery current of the battery, a terminal voltage of the battery, a surface temperature of the battery, and a core temperature of the battery.

The received battery condition signals may be used to estimate an SOH (state of health) of the battery and an SOC (state of charge) of the battery, as indicated at block 40. The SOH of the battery may include a capacity value for the battery, and/or an internal resistance value for the battery.

The estimated SOH and the estimated SOC may be used in combination with a degradation model to estimate one or more of a capacity loss-related parameter and a internal resistance-related parameter, as indicated at block 42. The estimated capacity loss-related parameter and/or the internal resistance-related parameter may be used to estimate a RUL (remaining useful life) value and/or a CBW (cumulative battery wear cost) value, as indicated at block 44. In some cases, estimating the RUL value and/or the CBW value may further include using a time of battery usage value. Estimating the RUL value and/or the CBW value may additionally or alternatively include using a charge throughput value.

In some cases, and as indicated at block 46, the method 36 may further include using a closed loop feedback to update the degradation model. The method 36 may further include storing the estimated RUL value over time and monitoring the estimated RUL value for sudden changes, as indicated at block 48.

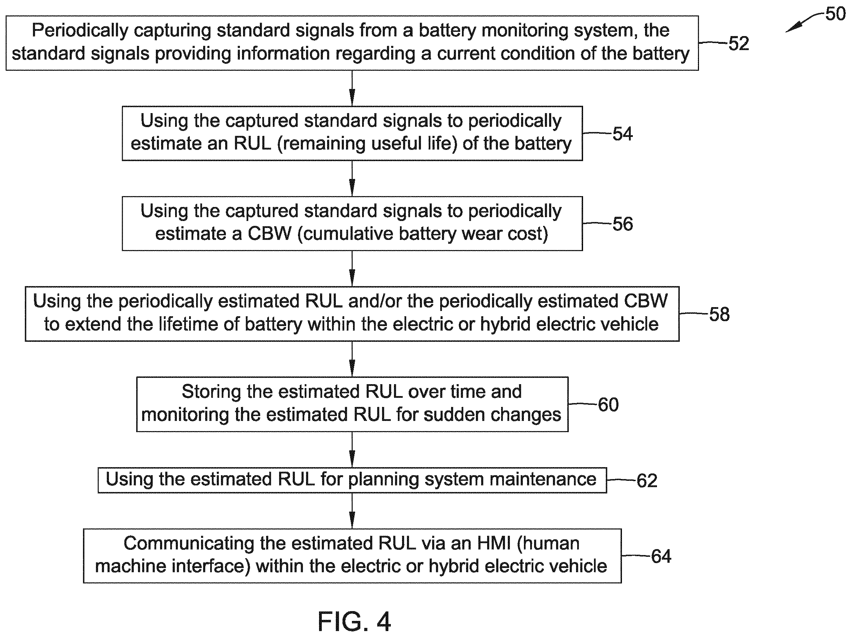

Figure 4 is a flow diagram showing an illustrative method 50 of optimizing battery life for a battery (such as the battery 11) within an electric or hybrid electric vehicle. The method 50 includes periodically capturing standard signals from a battery monitoring system, the standard signals providing information regarding a current condition of the battery, as indicated at block 52. The standard signals may include signals representing one or more of battery current, terminal voltage of the battery, surface temperature of the battery, and/or core temperature of the battery.

The captured standard signals are used to periodically estimate an RUL (remaining useful life) of the battery, as indicated at block 54. The periodically captured standard signals may be provided to a state and health estimation block that is configured to output information describing a state of health of the battery.

The captured standard signals are used to periodically estimate a CBW (cumulative battery wear) cost, as indicated at block 56. The periodically estimated RUL and/or the periodically estimated CBW are used to extend the lifetime of the battery within the hybrid vehicle, as indicated at block 58. Using the estimated RUL and the estimated CBW to extend the lifetime of the battery within the hybrid vehicle may include changing a control algorithm based on the estimated RUL and/or the estimated CBW.

In some instances, using the captured standard signals to periodically estimate the RUL and/or the CBW may include utilizing a degradation model of capacity loss and/or internal resistance growth. In some instances, using the captured standard signals to periodically estimate the RUL and/or the CBW may include utilizing a lifetime prediction filter block that receives as inputs one or more of time of battery usage, charge throughput, capacity loss, capacity loss rate, internal resistance growth, and internal resistance growth rate.

In some cases, and as indicated at block 60, the method 50 may further include storing the estimated RUL over time and monitoring the estimated RUL for sudden changes. The estimated RUL may be used for planning system maintenance, for example, as indicated at block 62. In some instances, the method 50 may additionally or alternatively include communicating the estimated RUL via an HMI (human machine interface) within the electric or hybrid electric vehicle. As an example, the estimated RUL may be communicated to a touch screen display viewable by the driver of the electric or hybrid electric vehicle.

There are mathematical models that may be used in estimating battery life. Equation (1) below provides an estimate for battery life in years:

$$L_{batt}[yr] = \frac{Q_{lifetime}[Ah]}{Q_{thrpt}\left[\frac{Ah}{yr}\right]} \qquad (1),$$

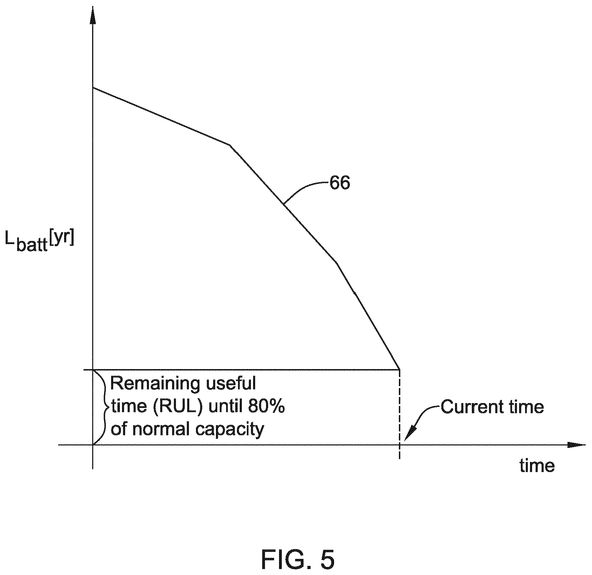

where $Q_{lifetime}$ is the lifetime throughput and $Q_{thrpt}$ is the annual throughput. It will be appreciated that $Q_{lifetime}$ depends on the battery degradation rate (and fitted degradation model) being a function of the SOC (state of charge), applied current and temperature. Figure 5 provides a graphical representation 66 of $L_{batt}$ plotted versus time. This illustrates how the remaining useful life (RUL) changes until reaching 80 percent of nominal capacity.

Equation (2) below provides a definition for $Q_{thrpt}$, which is the integrated current $I$ divided by the battery-in-usage time $T_u$:

$$Q_{thrpt}\left[\frac{Ah}{s}\right] = \frac{\int \frac{I}{3600} dt [Ah]}{T_u[s]} \qquad (2).$$

Equation (3) below defines the battery wear, in which $C_{newbatt}$ is the cost of a battery replacement and $n_{rt}$ is the

round trip efficiency:

$$C_{bw}\left[\frac{€}{Ah}\right] = \frac{C_{newbatt}[€]}{Q_{lifetime}\sqrt{n_{rt}}[Ah]} \quad (3).$$

Equation (4) provides the cumulative battery wear cost (CBW):

$$C_{cbw}[€] = \int_0^{T_u} C_{bw}Q_{thrpt}\, dt \quad (4).$$

Equation (5) provides the instantaneous time of degradation:

$$T_{EOL}[s] = \frac{Q_{20}-Q_{loss}[Ah]}{Q_r(SOC,I)\left[\frac{Ah}{s}\right]} \quad (5)$$

where $Q_{20}$ is the 20% charge of nominal (new) battery capacity and $Q_{loss}$ is the amount of degraded capacity.

Equation (6) provides the amount of lifetime charge, where $T_{EOL}$ provides useful information during charging where the degradation model has significant magnitude:

$$Q_{lifetime}[As] = \int_0^{T_{EOL}} |I|dt = T_{EOL}|I| \quad (6).$$

The computation of lifetime throughout $Q_{lifetime}$ is triggered during charging and is kept constant during discharging because during discharging, a calendar aging degradation rate is expected. $Q_{lifetime}$ is assumed to be an average value, rather than an instantaneously driven one by the $T_{EOL}$ (see equation (5) and equation (6)). For this reason, $Q_{lifetime}$ is filtered by either a running average filter, a weighted average filter or a mean average with forgetting factor.

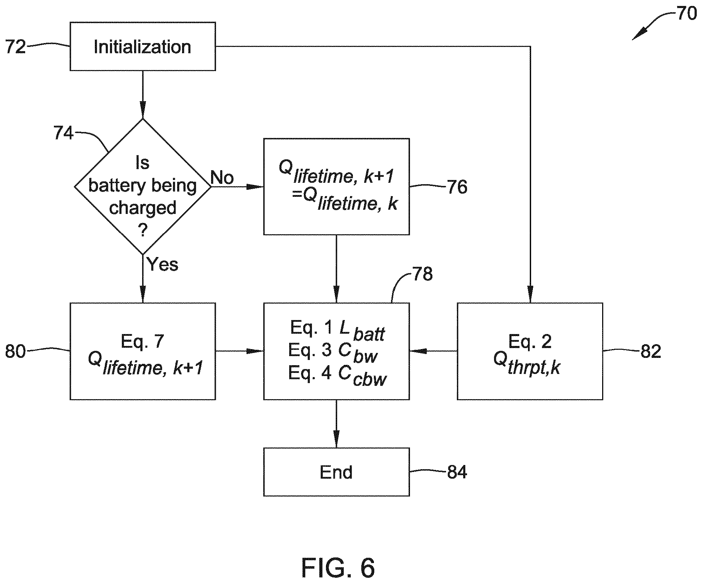

Figure 6 provides a flow diagram showing an illustrative method 70 for battery lifetime prognosis. The method 70 begins at an initialization block 72. At a decision block 74, a determination is made as to whether the battery is being charged. If not, control passes to block 76, where $\hat{Q}_{lifetime,k+1}$ is set equal to $\hat{Q}_{lifetime,k+1}$. Control then passes to block 78, where equation (1), equation (2) and equation (3) are relied upon.

Reverting momentarily to the decision block 74, if the determination is made that the battery is being charged, control passes to block 80, where the recursive mean average with forgetting factor is defined as shown in equation (7):

$$\hat{Q}_{lifetime,k+1} = \lambda\hat{Q}_{lifetime,k} + (1-\lambda)\,Q_{lifetime,k} \quad (7)$$

It will be appreciated that this technique incorporates all past inputs into the filter's output, not just the last n+1. The input measurement that is m∆t seconds old is discounted by a factor of λ and if λ is close to 0, the older inputs are forgotten quickly or immediately leading to less filtering. If λ is close to 1, however, the older inputs are forgotten relatively slowly leading to more filtering. While other averaging filters may be used, a recursive version with a forgetting factor formula is the most computationally efficient of all averaging filters. In some cases, control also passes from initialization block 72 to a block 82, where equation (2) is applied. From there, control passes to block 78. From block 78, control passes to an end block 84.

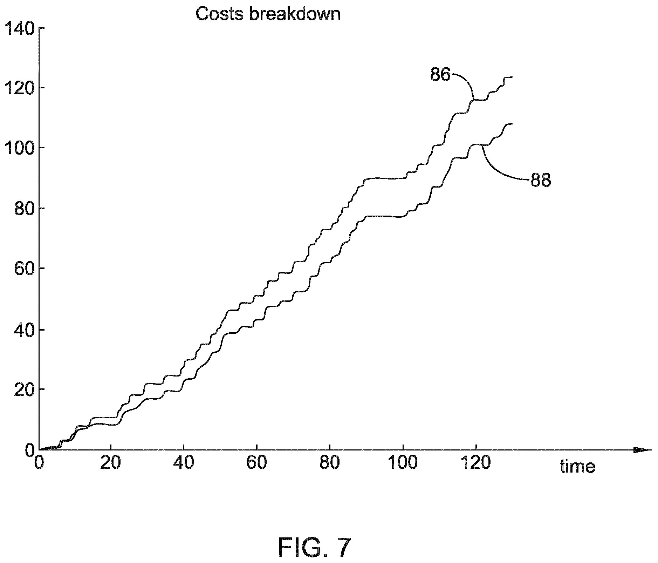

Figure 7 is a graphical representation showing how the overall cost of consuming the battery within an electric or hybrid electric vehicle may be altered by changing the control algorithm or changing parameters within the control algorithm in order to minimize. Cost is plotted versus time. A graph 86 represents a cumulative battery wear cost, which is an indication of how close the vehicle is to having to replace the battery, for a first control algorithm or scenario. A graph 88 represents the cumulative battery wear cost for a second control algorithm or scenario in which the control algorithm attempts to minimize the cumulative battery wear cost and thus maximize the expected life of the battery. It will be appreciated that the second control algorithm, represented by the graph 88, provides a lower cumulative battery wear cost, relative to that represented by the graph 86.

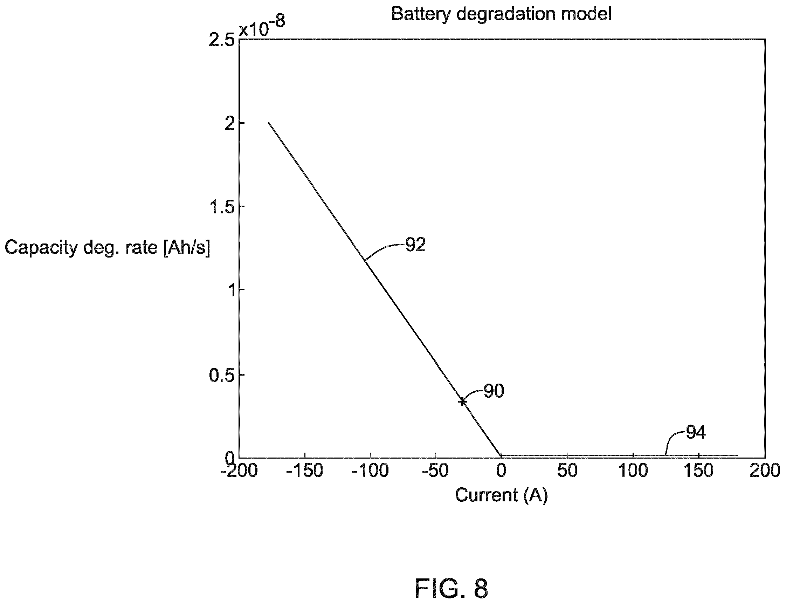

Figure 8 provides a graphical representation of a battery degradation model in which capacity is plotted versus current. In this example, it is assumed that the battery degradation model has a pure current dependency, and dependency on SOC and temperature have been omitted. A point 90 represents nominal while a line 92 indicates charging the battery and a line 94 indicates discharging the battery. In this particular example, the nominal battery capacity $Q$ = 5.5 Ah, the nominal charging current $I$ = -30A, the nominal SOC (state of charge) is 50 percent and the nominal degradation rate for the nominal current and nominal SOC $Qr$ (50, -30) = 3.4858x10$^{-9}$ $Ah/s$. These specific parameters may be adjusted for other examples using different battery types, sizes, etc.

The nominal degradation time at the beginning of life ($Q_{loss}$ =0) may be given by:

$$T_{EOL,Nom}[yr] = \frac{Q_{20}[Ah]}{Q_r(SOC,I)\left[\frac{Ah}{s}\right]} C_{sy} = \frac{1.1Ah}{3.4858X10^{-9}\left[\frac{Ah}{s}\right]} 3.1689 * 10^{-8}\left[\frac{Ah}{s}\right] = 10 \ years,$$

where $C_{sy}$ is a second to year conversion constant. The nominal $Q_{lifetime}$ is given by:

$$Q_{lifetime} = \frac{T_{EOL,Nom}|I|}{3600} C_{sy} = 2.63 \ MAh.$$

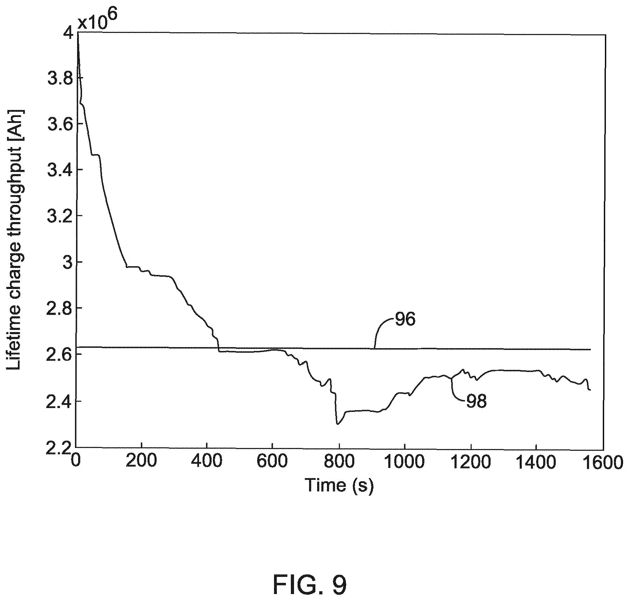

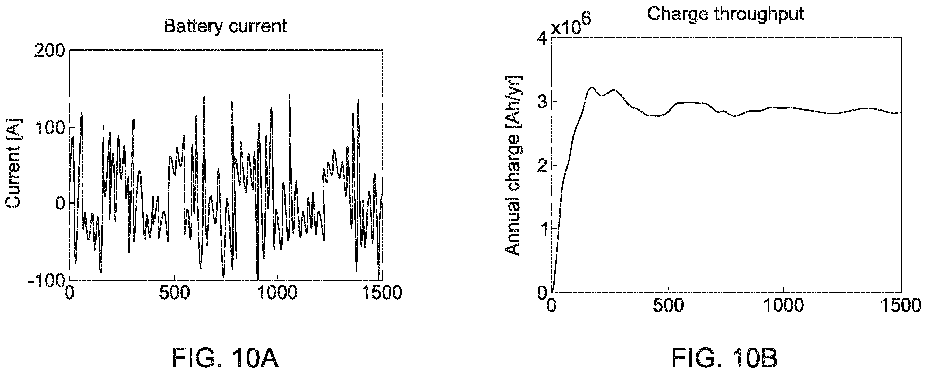

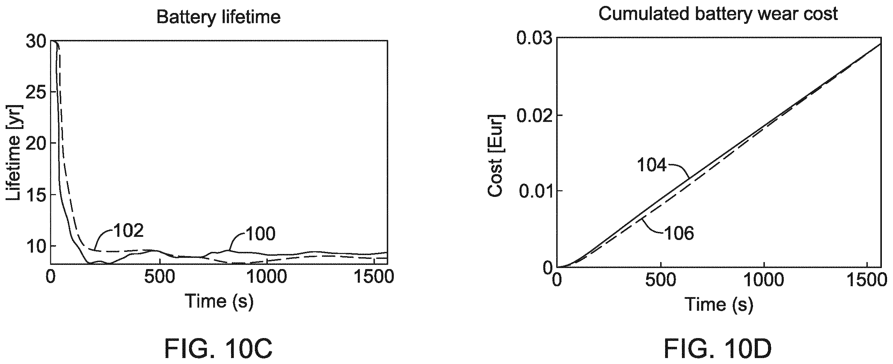

Figure 9 is a graphical representation of a demonstration example of a nominal scenario. In Figure 9, lifetime charge throughput is plotted against time. A line 96 shows the nominal (constant) value for the lifetime charge throughput while a line 98 shows the lifetime charge throughput in accordance with a model. Figure 10A shows battery current plotted against time in seconds, Figure 10B shows charge throughput plotted against time in seconds, Figure 10C shows battery lifetime plotted against time and Figure 10D shows cumulative battery wear cost plotted versus time. In Figure 10C, a line 100 shows the nominal battery lifetime while a line 102 shows the battery lifetime in accordance with the model. In Figure 10D, a line 104 shows the nominal cumulative battery wear cost while a line 106 shows the cumulative battery wear cost in accordance with the model.

These plots demonstrate the lifetime and cumulative battery wear for the nominal/constant lifetime charge throughput and model/filter case of lifetime charge throughput. The nominal case provides the RUL (here lifetime) that is based on the nominal lifetime charge throughput that is based on the nominal current reflecting typical load and nominal time of degradation. The model/filter, on the other hand, processes the lifetime charge based on evolving signals having more accurate and updated inputs.

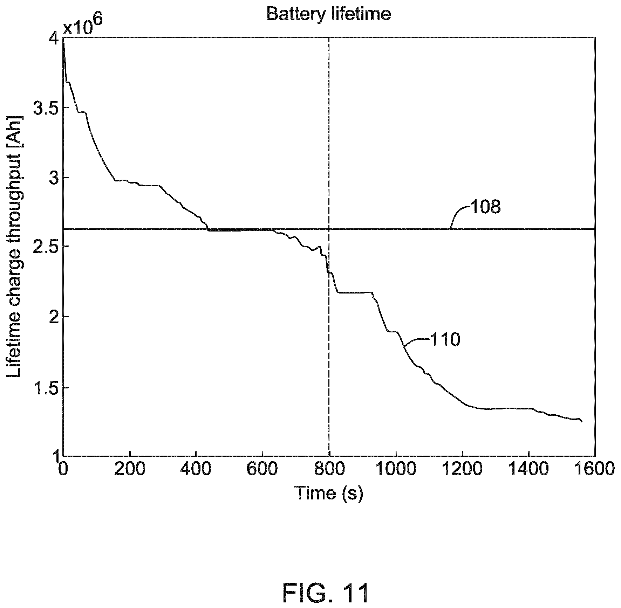

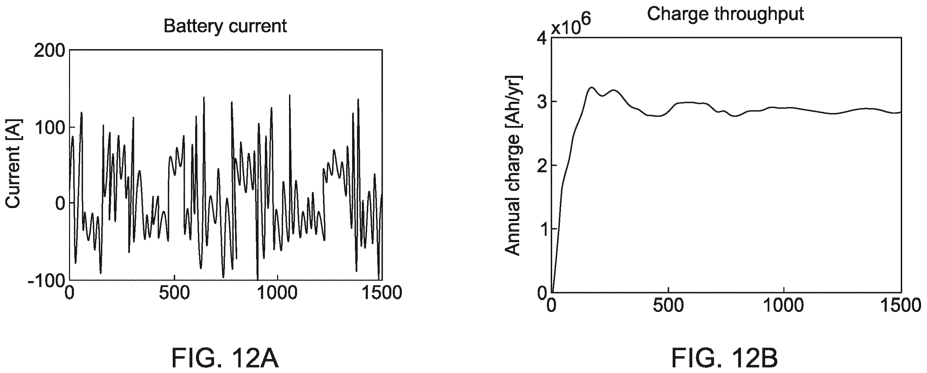

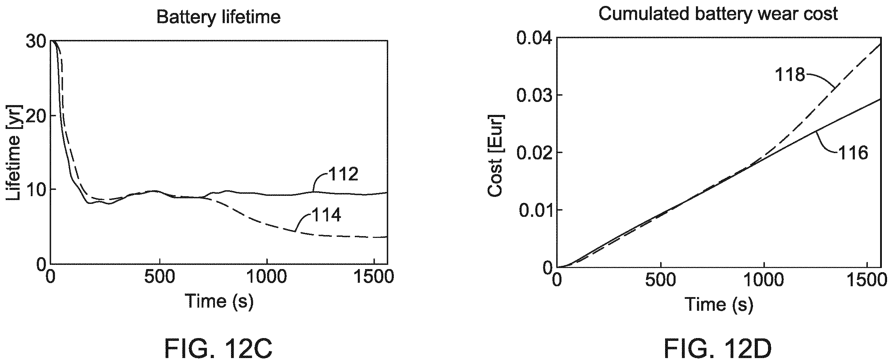

Figure 11 is a graphical representation of a demo example of a sudden capacity change scenario. A sudden capacity loss of 0.55 Ah (10 percent of nominal) occurs around time equals 800 seconds. In Figure 11, lifetime charge throughput is plotted against time. A line 108 shows the nominal (constant) value for the lifetime charge throughput while a line 110 shows the lifetime charge throughput in accordance with a model. Figure 12A shows battery current plotted against time, Figure 12B shows charge throughput plotted against time, Figure 12C shows battery lifetime plotted against time and Figure 12D shows cumulative battery wear cost plotted versus time. In Figure 12C, a line 112 shows the nominal battery lifetime while a line 114 shows the battery lifetime in accordance with the model. The line 114 starts to diverge from the line 112 after the sudden capacity change. In Figure 12D, a line 116 shows the nominal cumulative battery wear cost while a line 118 shows the cumulative battery wear cost in accordance with the model. The line 118 starts to diverge from the line 116 after the sudden capacity change.

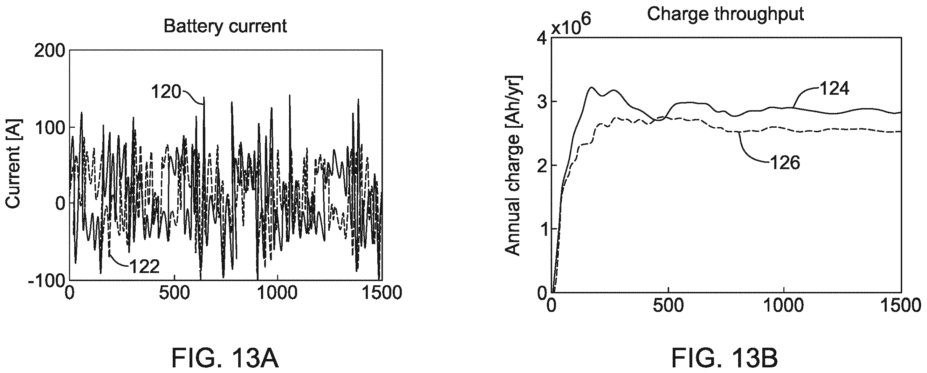

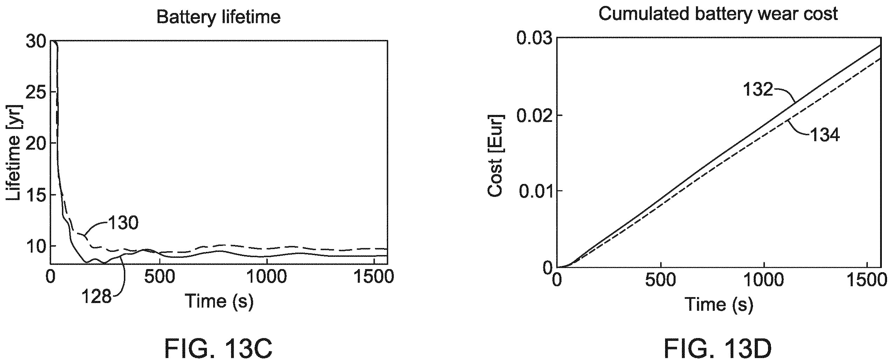

Figures 13A through 13D are graphical representations of various battery parameters showing changes as a result of using different control algorithms or strategies, demonstrating the usefulness of RUL and CBW. Figure 13A shows battery current plotted against time, Figure 13B shows charge throughput plotted against time, Figure 13C shows battery lifetime plotted against time and Figure 13D shows cumulative battery wear cost plotted versus time.

In Figure 13A, a line 120 represents a first control strategy while a line 122 represents a second control strategy. In Figure 13B, a line 124 represents the first control strategy while a line 126 represents the second control strategy. In Figure 13C, a line 128 represents the first control strategy while a line 130 represents the second control strategy. In Figure 13D, a line 132 represents the first control strategy and a line 134 represents the second control strategy.

As can be seen, two different control strategies can have a different effect on battery lifetime. It can be seen that the first control strategy generates a higher annual change and therefore wears the battery more than the second control strategy. The health-prediction filter based on the online processed battery current information predicts a higher RUL (or lifetime) and lower cumulative battery wear cost for the second control strategy. In some cases, the CBW indicator can enter the EPSC (energy power split controller) cost function and thus penalize the uneconomical usage of the battery 11.

In some instances, the RUL (remaining useful life) and the CBW (cumulative battery wear cost) that have been calculated for the battery 11 by the battery diagnostics system 14 may be used by an engine management system to alter the demanded torque profiles in order to maximize the life of the battery 11. A demanded torque profile defines, in part, how much power (torque) is demanded from the electric motor(s) that at least partially propel the vehicle, and thus defines in part when electrical power is demanded from the battery 11, and at what rate electrical power is demanded from the battery 11. The engine management system may rely upon other battery condition parameters as well, such as but not limited to the current charge state of the battery 11. In some cases, the engine management system may include an EPSC (energy power-split controller) that is configured to utilize the RUL and/or the CBW parameters to determine a demanded torque profile in order to maximize the lifetime of the battery, for example. In some examples, power split control (for a hybrid), or battery utilization (for an all-electric vehicle) may use an optimization problem to determine control parameters, such as by incorporating a model predictive control (MPC) analysis. In MPC, a cost function is minimized over a time horizon; the RUL and/or CBW may be used within the cost function of an MPC, or changes or impact to RUL and/or CBW may be accounted for within the cost function to penalize such changes. In some examples, a weighting term in an MPC or other optimization analysis may change in response to changes in RUL and/or CBW to penalize certain actions (such as penalizing actions requiring large torques) to extend battery life.

It will be appreciated that in a hybrid electric vehicle that includes both one or more electric motors as well as an internal combustion engine or fuel cell, for example, has the capability to adjust how much power is being demanded from the internal combustion engine or fuel cell at a particular time, relative to how much power is being demanded from the one or more electric motors. In some instances, demanding relatively less power from the one or more electric motors, and temporarily relying more on the internal combustion engine or fuel cell, may temporarily decrease effective fuel economy while increasing the expected life expectancy of the battery 11.

Additionally or alternatively, the EPSC may be configured to utilize the RUL and/or the CBW parameters in order to minimize wear of the battery 11. It will be appreciated that the life expectancy of the battery 11 and wear of the battery 11 are inversely related, i.e., decreasing battery wear increases battery life expectancy, and vice versa. The EPSC may be configured to solve an optimization problem on the prediction horizon by including RUL and/or CBW parameters as terms within the optimization problem directly, or by having one or more terms, weighting values, etc. in the optimization problem derive from the RUL and/or CBW.

In some instances, particularly for all electric vehicles that do not have a separate internal combustion engine or fuel cell, along with accompanying fuel source, the engine management system may include a vehicle cruise controller that generates a power profile for the vehicle that maximizes the lifetime of the battery 11 and/or minimizes battery wear. For example, the cruise controller may allow reduction in vehicle speed while going up a hill, and may make up for such a reduction in a subsequent downhill component of a travel route. In some instances, providing a little less power in response to the user stepping on the accelerator may help to extend the life expectancy of the battery 11, trading a small loss in total power for improving the life expectancy of the battery 11. In some cases, the vehicle cruise controller may solve an optimization problem on the prediction horizon with the CBW indicator embedded in the cost function.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic or optical disks, magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments can be used, such as by one of ordinary skill in the art upon reviewing the above description.

The Abstract is provided to allow the reader to quickly ascertain the nature of the technical disclosure. It is submitted with the understanding that it will not be used to interpret or limit the scope or meaning of the claims.

Also, in the above Detailed Description, various features may be grouped together to streamline the disclosure. This should not be interpreted as intending that an unclaimed disclosed feature is essential to any claim. Thus, the following claims are hereby incorporated into the Detailed Description as examples or embodiments, with each claim standing on its own as a separate embodiment, and it is contemplated that such embodiments can be combined with each other in various combinations or permutations. The scope of the protection should be determined with reference to the appended claims.

**Claims**

1. A method of diagnosing the health of a battery within an electric or hybrid electric vehicle, the battery configured to provide power for operation of the electric or hybrid electric vehicle, the electric or hybrid electric vehicle including a battery monitoring system, the method comprising:

receiving (38) battery condition signals from the battery monitoring system;
using (40) the received battery condition signals to estimate an SOH, state of health, of the battery and an SOC, state of charge, of the battery;
using (42) the estimated SOH and the estimated SOC in combination with a degradation model to estimate one or more of a capacity loss-related parameter and an internal resistance-related parameter;
using (44) the estimated capacity loss-related parameter and/or the internal resistance-related parameter to estimate a RUL, remaining useful life, value ;
using (46) a closed loop feedback to update the degradation model; and
storing (48) the estimated RUL value over time and **characterised by**
monitoring the estimated RUL value for sudden changes,
wherein the method further comprises:
determining, using the estimated RUL value, an altered demanded torque profile from electric motors of the electric or hybrid electric vehicle, the altered demanded torque profile for increasing the life of the battery, wherein the step of determining the altered demanded torque profile comprises using a model predictive control, MPC, analysis to minimize a cost function associated with the RUL value over a time horizon, wherein weighting terms in the MPC analysis are changed in response to sudden changes in the estimated RUL value so as to penalize actions that caused monitored sudden changes in the estimated RUL value.

2. The method of claim 1, wherein estimating the RUL value further comprises using a time of battery usage value or using a charge throughput value.

3. The method of any preceding claim, wherein the SOH of the battery comprises a capacity value for the battery.

4. The method of any preceding claim, wherein the SOH of the battery comprises an internal resistance value for the battery.

5. The method of any preceding claim, wherein receiving battery condition signals from the battery monitoring system comprises receiving battery condition signals representing one or more of:

a battery current of the battery;
a terminal voltage of the battery;
a surface temperature of the battery; and
a core temperature of the battery.

6. A system for providing power within an electric or hybrid electric vehicle, the system comprising:

a battery;
a battery monitoring system configured to output signals representative of conditions within the battery;
a battery diagnostics system configured to receive the signals outputted by the battery monitoring system, the battery diagnostics system including:

a state and health estimation block configured to output signals representing a current health state of the battery; and
a health prognostics block configured to receive the signals outputted by the state and health estimation block, the health prognostics block including:

a degradation model configured to output signals representing a loss of capacity within the battery and/or an internal resistance within the battery; and
a lifetime prediction block configured to receive the outputted signals from the degradation model and to estimate an RUL (remaining useful life) value for the battery, to use a closed-loop feedback to update the degradation model and to store the estimated RUL value over time and **characterised in that**:

the estimated RUL value is monitored for sudden changes; and
an engine management system configured to determine, using the estimated RUL value, an altered demanded torque profile from electric motors of the electric or hybrid electric vehicle, the altered demanded torque profile for increasing the life of the battery, wherein the altered demanded torque profile is determined using a model predictive control, MPC, analysis adapted to minimize a cost function associated with the RUL value over a time horizon, wherein weighting terms in the MPC analysis are configured to be changed in response to sudden changes in the estimated RUL value so as to penalize actions that caused monitored sudden changes in the estimated RUL value.

7. The system of claim 6, wherein the lifetime prediction block is configured to estimate the RUL value for the battery based on the signals outputted by the degradation model.

8. The system of claim 7, wherein the lifetime prediction block is configured to estimate the RUL value for the battery based also on a time of battery usage value and/or a charge throughput value for the battery.

**Patentansprüche**

1. Verfahren zur Diagnose des Gesundheitszustands einer Batterie innerhalb eines Elektro- oder Hybrid-Elektrofahrzeugs, wobei die Batterie dazu konfiguriert ist, Leistung für den Betrieb des Elektro- oder Hybrid-Elektrofahrzeugs bereitzustellen, wobei das Elektro- oder Hybrid-Elektrofahrzeug ein Batterieüberwachungssystem enthält, wobei das Verfahren Folgendes umfasst:

Empfangen (38) von Batteriezustandssignalen vom Batterieüberwachungssystem;
Verwenden (40) der empfangenen Batteriezustandssignale, um einen SOH, Gesundheitszustand, der Batterie und einen SOC, Ladezustand, der Batterie zu schätzen;
Verwenden (42) des geschätzten SOH und des geschätzten SOC in Kombination mit einem Verschlechterungsmodell, um einen oder mehrere aus einem kapazitätsverlustbezogenen Parameter und einem innenwiderstandsbezogenen Parameter zu schätzen;
Verwenden (44) des geschätzten kapazitätsverlustbezogenen Parameters und/oder des innenwiderstandsbezogenen Parameters, um einen RUL-Wert, Wert der restlichen Lebensdauer, zu schätzen;
Verwenden (46) eines geschlossenen Feedback-Kreises, um das Verschlechterungsmodell zu aktualisieren; und
Speichern (48) des geschätzten RUL-Werts im Laufe der Zeit und **gekennzeichnet durch** das Überwachen des geschätzten RUL-Werts auf plötzliche Veränderungen,
wobei das Verfahren ferner Folgendes umfasst:
Bestimmen, unter Verwendung des geschätzten RUL-Werts, eines geänderten angeforderten Drehmomentprofils von Elektromotoren des Elektro- oder Hybrid-Elektrofahrzeugs, wobei das geänderte angeforderte Drehmomentprofil zum Erhöhen der Lebensdauer der Batterie dient, wobei der Schritt des Bestimmens des geänderten angeforderten Drehmomentprofils das Verwenden einer Modellvorhersagesteuerungsanalyse, MPC-Analyse, umfasst, um eine Kostenfunktion zu minimieren, die dem RUL-Wert über einen Zeithorizont zugeordnet ist, wobei Gewichtungsbedingungen in der MPC-Analyse in Reaktion auf plötzliche Veränderungen des geschätzten RUL-Werts geändert werden, um Vorgänge als nachteilig zu bewerten, die überwachte plötzliche Veränderungen des geschätzten RUL-Werts verursacht haben.

2. Verfahren nach Anspruch 1, wobei das Schätzen des RUL-Werts ferner das Verwenden eines Werts der Nutzungsdauer der Batterie oder eines Werts des Ladungsdurchsatzes umfasst.

3. Verfahren nach einem der vorhergehenden Ansprüche, wobei der SOH der Batterie einen Kapazitätswert für die Batterie umfasst.

4. Verfahren nach einem der vorhergehenden Ansprüche, wobei der SOH der Batterie einen Innenwiderstandswert für die Batterie umfasst.

5. Verfahren nach einem der vorhergehenden Ansprüche, wobei das Empfangen von Batteriezustandssignalen vom Batterieüberwachungssystem das Empfangen von Batteriezustandssignalen umfasst, die eines oder mehrere von Folgendem darstellen:

einen Batteriestrom der Batterie;
eine Anschlussspannung der Batterie;
eine Oberflächentemperatur der Batterie; und

eine Kerntemperatur der Batterie.

6. System zum Bereitstellen von Leistung innerhalb eines Elektro- oder Hybrid-Elektrofahrzeugs, wobei das System Folgendes umfasst:

eine Batterie;

ein Batterieüberwachungssystem, das dazu konfiguriert ist, Signale auszugeben, die Zustände innerhalb der Batterie darstellen;

ein Batteriediagnosesystem, das dazu konfiguriert ist, die von dem Batterieüberwachungssystem ausgegebenen Signale zu empfangen, wobei das Batteriediagnosesystem Folgendes enthält:

einen Zustands- und Gesundheitsschätzungsblock, der dazu konfiguriert ist, Signale auszugeben, die einen aktuellen Gesundheitszustand der Batterie darstellen; und

einen Gesundheitsprognoseblock, der dazu konfiguriert ist, die von dem Zustands- und Gesundheitsschätzungsblock ausgegebenen Signale zu empfangen, wobei der Gesundheitsprognoseblock Folgendes enthält:

ein Verschlechterungsmodell, das dazu konfiguriert ist, Signale auszugeben, die einen Kapazitätsverlust innerhalb der Batterie und/oder einen Innenwiderstand innerhalb der Batterie darstellen; und

einen Lebensdauer-Vorhersageblock, der dazu konfiguriert ist, die von dem Verschlechterungsmodell ausgegebenen Signale zu empfangen und einen RUL-Wert für die Batterie zu schätzen, einen geschlossenen Feedback-Kreis zu verwenden, um das Verschlechterungsmodell zu aktualisieren und den geschätzten RUL-Wert (Wert der restlichen Lebensdauer) im Laufe der Zeit zu speichern, und **dadurch gekennzeichnet ist, dass**:

der geschätzte RUL-Wert auf plötzliche Veränderungen überwacht wird; und

ein Motormanagementsystem, das dazu konfiguriert ist, unter Verwendung des geschätzten RUL-Werts ein geändertes angefordertes Drehmomentprofil von Elektromotoren des Elektro- oder Hybrid-Elektrofahrzeugs zu bestimmen, wobei das geänderte angeforderte Drehmomentprofil zum Erhöhen der Lebensdauer der Batterie dient, wobei das geänderte angeforderte Drehmomentprofil unter Verwendung einer Modellvorhersagesteuerungsanalyse, MPC-Analyse, bestimmt wird, die dazu ausgelegt ist, eine Kostenfunktion zu minimieren, die dem RUL-Wert über einen Zeithorizont zugeordnet ist, wobei Gewichtungsbedingungen in der MPC-Analyse dazu konfiguriert sind, in Reaktion auf plötzliche Veränderungen des geschätzten RUL-Werts geändert zu werden, um Vorgänge als nachteilig zu bewerten, die überwachte plötzliche Veränderungen des geschätzten RUL-Werts verursacht haben.

7. System nach Anspruch 6, wobei der Lebensdauervorhersageblock dazu konfiguriert ist, den RUL-Wert für die Batterie basierend auf den von dem Verschlechterungsmodell ausgegebenen Signale zu schätzen.

8. System nach Anspruch 7, wobei der Lebensdauervorhersageblock dazu konfiguriert ist, den RUL-Wert für die Batterie auch basierend auf einem Wert der Nutzungsdauer der Batterie und/oder einem Wert des Ladungsdurchsatzes für die Batterie zu schätzen.

## Revendications

1. Procédé de diagnostic de la santé d'une batterie dans un véhicule électrique électrique ou hybride, la batterie étant configurée pour fournir de la puissance pour le fonctionnement du véhicule électrique électrique ou hybride, le véhicule électrique électrique ou hybride incluant un système de surveillance de batterie, le procédé comprenant :

la réception (38) de signaux d'état de batterie à partir du système de surveillance de batterie ;

l'utilisation (40) des signaux d'état de batterie reçus pour l'estimation d'un SOH, état de santé, de la batterie et d'un SOC, état de charge, de la batterie ;

l'utilisation (42) du SOH estimé et du SOC estimé en combinaison avec un modèle de dégradation pour l'estimation de l'un ou de plusieurs parmi un paramètre associé à la perte de capacité et un paramètre associé à la résistance interne ;

l'utilisation (44) du paramètre associé à la perte de capacité et/ou du paramètre associé à la résistance interne pour l'estimation d'une valeur RUL, vie utile restante ;

l'utilisation (46) d'une rétroaction en boucle fermée pour la mise à jour du modèle de dégradation ; et

le stockage (48) de la valeur RUL estimée dans le temps et **caractérisé par**

la surveillance de la valeur RUL quant à des changements soudains,

dans lequel le procédé comprend en outre :

la détermination, à l'aide de la valeur RUL estimée, d'un profil de couple requis altéré à partir de moteurs électriques du véhicule électrique électrique ou hybride, le profil de couple requis altéré pour augmenter la longévité de la batterie, dans lequel l'étape de détermination du profil de couple requis altéré comprend l'utilisation d'une analyse de contrôle prédictif de modèle, MPC, visant à minimiser une fonction de coût associée à la valeur RUL sur un horizon temporel, dans lequel des termes de pondération dans l'analyse MPC sont modifiés en réponse à des changements soudains dans la valeur RUL estimée, de manière à pénaliser des actions ayant causé des changements soudains surveillés dans la valeur RUL estimée.

2. Procédé selon la revendication 1, dans lequel la valeur RUL estimée comprend l'utilisation d'un temps de valeur d'usage de batterie ou l'utilisation d'une valeur de débit de charge.

3. Procédé selon l'une quelconque des revendications précédentes, dans lequel le SOH de la batterie comprend une valeur de capacité pour la batterie.

4. Procédé selon l'une quelconque des revendications précédentes, dans lequel le SOH de la batterie comprend une valeur de résistance interne pour la batterie.

5. Procédé selon l'une quelconque des revendications précédentes, dans lequel la réception de signaux d'état de batterie à partir du système de surveillance de batterie comprend la réception de signaux d'état de batterie représentant l'un ou plusieurs parmi :

un courant de batterie de la batterie ;

une tension de borne de la batterie ;

une température de surface de la batterie ; et

une température interne de la batterie.

6. Système d'alimentation en puissance dans un véhicule électrique électrique ou hybride, le système comprenant :

une batterie ;

un système de surveillance de batterie configuré pour émettre des signaux représentant des états dans la batterie ;

un système de diagnostic de batterie configuré pour recevoir les signaux émis par le système de surveillance de batterie, le système de diagnostic de batterie incluant :

un bloc d'estimation d'état et de santé configuré pour émettre des signaux représentant un état de santé actuel de la batterie ; et

un bloc de pronostic de santé configuré pour recevoir les signaux émis par le bloc d'estimation d'état et de santé, le bloc de pronostic de santé incluant :

un modèle de dégradation configuré pour émettre des signaux représentant une perte de capacité dans la batterie et/ou une résistance interne dans la batterie ; et

un bloc de prévision de longévité configuré pour recevoir les signaux émis à partir du modèle de dégradation et pour estimer une valeur RUL (vie utile restante) pour la batterie, pour utiliser une rétroaction en boucle fermée pour la mise à jour du modèle de dégradation et pour stocker la valeur RUL estimée dans le temps, et **caractérisé en ce que** :

la valeur RUL estimée est surveillée quant à des changements soudains ; et

un système de gestion de moteur configuré pour déterminer, à l'aide de la valeur RUL estimée, un profil de couple requis altéré à partir de moteurs électriques du véhicule électrique électrique ou hybride, le profil de couple requis altéré pour augmenter la longévité de la batterie, dans lequel le profil de couple requis altéré est déterminé à l'aide d'une analyse de contrôle prédictif de modèle, MPC, adaptée pour minimiser une fonction de coût associée à la valeur RUL sur un horizon temporel, dans lequel des termes de pondération dans l'analyse MPC sont configurés pour être modifiés en réponse à des changements soudains dans la valeur RUL estimée, de manière à pénaliser des actions ayant causé des changements soudains surveillés dans la valeur RUL estimée.

7. Système selon la revendication 6, dans lequel le bloc de prévision de longévité est configuré pour estimer la valeur RUL pour la batterie sur la base des signaux émis par le modèle de dégradation.

8. Système selon la revendication 7, dans lequel le bloc de prévision de longévité est configuré pour estimer la valeur RUL pour la batterie également sur la base d'un temps de valeur d'usage de batterie et/ou d'une valeur de débit de charge pour la batterie.

FIG. 1

EP 4 239 351 B1

FIG. 2

EP 4 239 351 B1

```
                                                                    ┌─36
  ┌──────────────────────────────────────────────────────────────┐
  │ Receiving battery condition signals from the battery monitoring system │──38
  └──────────────────────────────────────────────────────────────┘
                              │
  ┌──────────────────────────────────────────────────────────────┐
  │ Using the received battery condition signals to estimate an SOH (state │──40
  │  of health)  of the battery and an SOC (state of charge) of the battery │
  └──────────────────────────────────────────────────────────────┘
                              │
  ┌──────────────────────────────────────────────────────────────┐
  │ Using the estimated SOH and the estimated SOC in combination with a degradation model to │──42
  │ estimate one or more of a capacity loss-related parameter and a internal resistance-related parameter │
  └──────────────────────────────────────────────────────────────┘
                              │
  ┌──────────────────────────────────────────────────────────────┐
  │ Using the estimated capacity loss-related parameter and/or the internal resistance-related parameter │──44
  │  to estimate a RUL (remaining useful life) value and/or a CBW (cumulative battery wear cost) value │
  └──────────────────────────────────────────────────────────────┘
                              │
  ┌──────────────────────────────────────────────────────────────┐
  │ Using a closed loop feedback to update the degradation model │──46
  └──────────────────────────────────────────────────────────────┘
                              │
  ┌──────────────────────────────────────────────────────────────┐
  │ Storing the estimated RUL value over time and │──48
  │ monitoring the estimated RUL value for sudden changes │
  └──────────────────────────────────────────────────────────────┘
```

FIG. 3

```
┌────────────────────────────────────────────────────────────────────────┐
│ Periodically capturing standard signals from a battery monitoring system, the │──52        ╱──50
│ standard signals providing information regarding a current condition of the battery │
└────────────────────────────────────────────────────────────────────────┘
                                     │
                                     ▼
          ┌──────────────────────────────────────────────┐
          │ Using the captured standard signals to periodically │──54
          │ estimate an RUL (remaining useful life) of the battery │
          └──────────────────────────────────────────────┘
                                     │
                                     ▼
          ┌──────────────────────────────────────────────┐
          │ Using the captured standard signals to periodically │──56
          │ estimate a CBW (cumulative battery wear cost) │
          └──────────────────────────────────────────────┘
                                     │
                                     ▼
   ┌────────────────────────────────────────────────────────────────┐
   │ Using the periodically estimated RUL and/or the periodically estimated CBW │──58
   │ to extend the lifetime of battery within the electric or hybrid electric vehicle │
   └────────────────────────────────────────────────────────────────┘
                                     │
                                     ▼
          ┌──────────────────────────────────────────────┐
          │ Storing the estimated RUL over time and │──60
          │ monitoring the estimated RUL for sudden changes │
          └──────────────────────────────────────────────┘
                                     │
                                     ▼
          ┌──────────────────────────────────────────────┐
          │ Using the estimated RUL for planning system maintenance │──62
          └──────────────────────────────────────────────┘
                                     │
                                     ▼
          ┌──────────────────────────────────────────────┐
          │ Communicating the estimated RUL via an HMI (human │──64
          │ machine interface) within the electric or hybrid electric vehicle │
          └──────────────────────────────────────────────┘
```

FIG. 4

FIG. 5

FIG. 6

Costs breakdown

FIG. 7

FIG. 8

EP 4 239 351 B1

FIG. 9

FIG. 10B

FIG. 10A

EP 4 239 351 B1

Battery lifetime

FIG. 10C

Cumulated battery wear cost

FIG. 10D

FIG. 11

EP 4 239 351 B1

FIG. 12B

FIG. 12A

Cumulated battery wear cost

Cost [Eur]

Time (s)

FIG. 12D

Battery lifetime

Lifetime [yr]

Time (s)

FIG. 12C

FIG. 13B

FIG. 13A

FIG. 13D

Cumulated battery wear cost

132
134

Cost [Eur]
0.03
0.02
0.01
0

Time (s)
500
1000
1500

FIG. 13C

Battery lifetime

130
128

Lifetime [yr]
30
25
20
15
10

Time (s)
500
1000
1500

**EP 4 239 351 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010055271 A1

- US 10209314 B2